**Europäisches Patentamt**

**European Patent Office**

**Office européen des brevets**

(19)

(11) **EP 1 089 082 A1**

(12) **EUROPEAN PATENT APPLICATION**

(43) Date of publication:
**04.04.2001 Bulletin 2001/14**

(51) Int Cl.⁷: **G01R 31/316**

(21) Application number: **99870202.1**

(22) Date of filing: **30.09.1999**

(84) Designated Contracting States:
**AT BE CH CY DE DK ES FI FR GB GR IE IT LI LU MC NL PT SE**
Designated Extension States:
**AL LT LV MK RO SI**

(71) Applicants:
• **INTERUNIVERSITAIR MICRO-ELEKTRONICA CENTRUM VZW**
**3001 Heverlee (BE)**
• **Katholieke Hogeschool Brugge-Oostende Vereniging Zonder Winstbejag**
**8000 Brugge (BE)**

(72) Inventors:
• **Manhaeve, Hans**
**8200 St-Michiels Brugge (BE)**
• **Kerckenaere, Stefaan**
**8480 Eernegem (BE)**

(74) Representative: **Van Malderen, Joelle et al**
**Office Van Malderen,**
**Place Reine Fabiola 6/1**
**1083 Bruxelles (BE)**

(54) **A method and apparatus for testing supply connections**

(57) The invention presents an apparatus and method for testing supply connections (80) of an electronic device (10) by using a current mirror (20) configuration through using a particular connection of the branches of the current mirror to the supply line. Such connection results in unbalanced operation of the current mirror but depending whether said supply connection under test is proper or not, said unbalance is essentially different, resulting in a high sensitivity of the invented test device.

Fig. 1

## Description

## Field of the invention

The invention relates to testing supply connections of electronic circuits.

## Background of the invention

On-board monitor, thus being integrated with the functional circuit on the same silicon or substrate, for the verification of the power and ground soldering connections of a circuit with multiple power and ground pins, when the package containing the circuit is mounted on a PCB board or an interconnection substrate. Such a monitor becomes more important as the number of device pins as well as the number of supply and ground pins increases and the pin dimensions of the package are decreasing.

A currently used inspection technique is for instance X-ray inspection.

Multiple power/ground pin connections cannot be tested easily once the package is mounted on the board. Electrical testing techniques fail because the power/ground pins are connected in parallel between the package and the board. Hence a failing connection to one of these pins only marginally affect the overall contact properties, which when considering device tolerances makes it impossible to draw a clear conclusion. Despite the fact that due to a missing/failing connection the overall power/ground connection parameters are only slightly modified, such a problem will affect circuit operation, performance and reliability, when designers cannot afford as many power pins as required to have adequate margins [M. Tegethoff, K. Parker, K. Lee, "Opens Board Test Coverage : When is 99% really 40%", Proceedings of the International Test Conference 1996 ITC96, pp. 333-339, October 20-25, 1996, Washington DC, USA].

Verifying the connectivity of a power/ground pin is easy when only one power/ground pin is used to feed a circuit, as a connectivity problem will result in a functional failure of the circuit. However when the circuit is fed through multiple power/ground pins then verifying that each of these pins is connected properly is a difficult tasks as they are normally tied together electrically as well on the board as well in the circuit and act as a set of parallel connection paths.

To solve this problem, a circuit is needed which is capable of verifying each power/ground pin connection independently, under the constraint that they are all tied up at board level and in most cases also at circuit level, and without affecting the supply/ground level of the circuit which is fed by these pins. Taken into consideration the desired very low resistance (order of magnitude : 10 mΩ) of each power/ground connection between bonding pad and power/ground ring, the circuit should be highly sensitive. Further more to be of practical use, the operation of the test circuit should not be affected by process parameter variations and tolerances (excluding the need for calibration) and provide a high repeatability of the test results, even under different test conditions.

Current state of the art verification techniques do not provide such characteristics. State of the art techniques include for instance the use of vision techniques and the use of current ($I_{DDQ/T}$) monitors. Vision techniques, such as the use of X-ray inspection, are expensive and time consuming and their application is limited in function of pin pitches and package types [J. Titus, B. Kerridge, "X-Ray Systems Reveal Hidden Defects", Test & Measurement Europe, August-September 1998, pp 8-19.]. Traditional current monitors are not sensitive enough, in most cases affect the supply levels of the circuit under test and require calibration procedures to cope with process parameter variations and tolerances.

## Aim of the invention

It is the aim of the invention to present an apparatus and method for testing supply connections of electronic circuits having a high sensitivity and not showing the drawbacks of the state of the art solutions.

## Summary of the invention

In a first aspect of the invention a test device for testing a supply connection of an electronic device by measuring a test current flowing in said supply connection is presented. Said test current flows from the power supply in said supply connection. A current can also flow through the supply connection.

Said test device comprises at least of a current mirror, having at least two branches. At least one end of each of said branches is connected to a different location of the supply connection to said electronic device through connections. Said current mirror is adapted for generating an output voltage on line, being related to said test current. It must be mentioned that in a current mirror, in a typical operation, currents in said branches are generated which are proportional to each other with a fixed proportionality factor being determined by the parameters of the transistors in the branches of said current mirror. In the invention said typical operation of a current mirror is not exploited. Indeed said current mirror generates an output voltage on line being related to said test current and therefore generates currents in said branches whereby said proportionality factor is not necessarily respected. Still the terminology current mirror can be exploited as the circuitry still matches the current mirror layout.

In a preferred embodiment of this aspect of the invention, said test device further comprises means for forcing said test current through said supply connection. Said means can be a switch connected to ground. Ground and power supply can be reversed.

In another embodiment of this aspect of the invention said test device comprises means for sampling said output voltage.

In an embodiment of this aspect of the invention said test device said test is integrated with said electronic device on one integrated circuit.

In an embodiment of this aspect of the invention said test device is used for testing a CMOS electronic device.

In an embodiment of this aspect of the invention said test device is such that said test current flows also in said electronic device. Said switch is then not necessary.

In a second aspect of the invention a method for testing a supply connection of an electronic device by measuring a test current flowing from the power supply in said supply connection is presented. A current can also flow through the supply connection.

Said method comprises at least of generating an output voltage on line with at least a current mirror. Said current mirror is characterized by at least two branches. At least one end of each of said branches is connected to a different location of the supply connection to said electronic device via connections. Said output voltage on line is related to said test current. It must be mentioned that in a typical operation said current mirror generates currents in said branches being proportional with a fixed proportionality constant. In the invention said typical operation is not exploited. Instead the current mirror generates currents in said branches such that an output voltage being related to said test current. The proportionality between currents is therefore not respected.

In an embodiment of said second aspect of the invention said test current is forced through said supply connection for instance via a switch to the ground. Note that power supply and ground can be reversed.

In an embodiment of said second aspect of the invention the following steps are as follow.

- In a first step a first output voltage being said output voltage on line is determined or measured for zero test current by said means.
- In a second step a second output voltage being said output voltage is determined or measured by said means while forcing said test current through said supply line. Said first step and second step can be reversed.
- In a third step a third output voltage on line is generated by said means. Said third output voltage is based on said first and second output voltage.

In an embodiment of said second aspect of the invention a CMOS electronic device is tested.

In an embodiment of said second aspect of the invention said test current also flows through said electronic device. Then no switch is necessary.

## Brief description of drawings

Figure 1 shows a general setting for the invention.

Figure 2 shows a potential setting for the invention, which fits in the general setting of Figure 1.

Figure 3 shows a typical current mirror configuration, which can be used in the invention.

Figure 4 shows a simulation test structure, according to the invention, wherein three test devices, are connected in between an outer supply voltage ring and an inner supply voltage ring.

Figure 5 represents a test device, according to a preferred embodiment of the invention.

Figure 6 shows voltage outputs of the branches of said test device of Figure 5.

Figure 7 shows the output of said test device of Figure 5.

Figure 8 shows the time dynamics of the testing method, by distinguishing non-testing and testing phases.

## Detailed description of several embodiments of the present invention

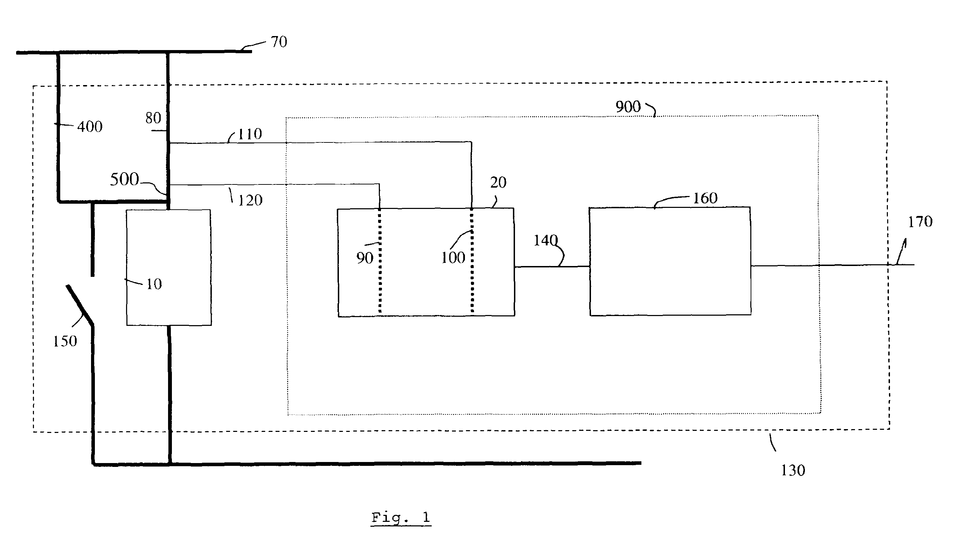

Figure 1 shows a general setting for the present invention. The device under test (10) is connected to at least two power supply connections (400) and (80). Connection to the supply (80) is under test. A switch (150) for forcing a test current is present. The test device, comprises of at least two branches (90) and (100), organized as in a current mirror configuration. Said branches are connected via (110) and (120) to different locations on the supply line (80).

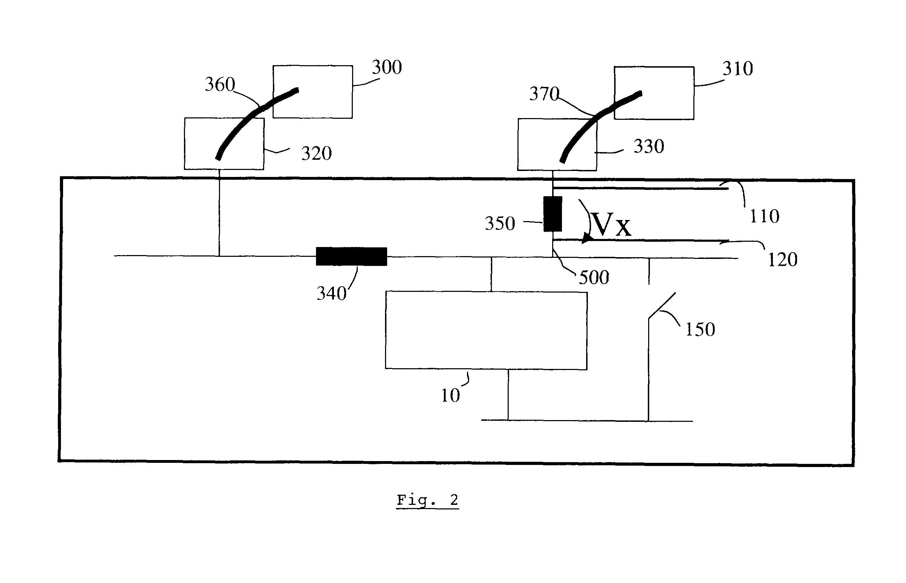

Figure 2 shows a potential setting for the invention, which fits in the general setting of Figure 1. The device under test (1) is connected to at least two power connections, here comprises of off-chip connectors (300)(310), on-chip connectors (320)(330) and soldering (360)(370). It is indicated that there is a voltage drop over the resistance (350).

A potential setting in which the invention can be applied is shown in Figure 2, showing the electronic device (10), being provided with a supply voltage and supply current via a plurality of off-chip connections. The blocks (300) and (310) represent the off-chip connectors. The blocks (320) and (330) represent the connectors of the chip. (360) and (370) represent soldering from the off-chip to chip connectors. It is shown that the electronic device (10) is located nearby the connection path (310), (330). Therefore the resistance of the supply line from (310) towards (10) can be considered to be lower than the resistance of the supply line from (300) towards (10) if the assumption can be made that said connection is properly made. (340) represents the additional resistance due to the larger distance from the electronic device to (300). The invented device is made for testing such supply connections. Suppose that the connection via (310), (370) and (330) is under test. The latter connection is represented in Figure 1 as (80). The longer distance connection is then represented as (400). It can be said that, when the connection (80) is properly made, its resistance will be considerably smaller than the resistance of the supply connection (400). (350) represents the resistance of the part of the supply line (80) in between the two branches (110) (120) of the invented device, being connected to said supply line. Said resistance can deliberately be foreseen or can be the parasitic resistance of that part. Typically values for the resistance of the bonding and soldering (360) (370) is 200 milli Ohm. The resistance (350) has a typical value of 10 milli Ohm while the resistance (340) is typically 300 milli ohm. Naturally the invention is not limited to such values. Vx is defined to be voltage drop over the resistance (350).

For the configuration depicted by Figure 2 and abstracted in Figure 1, four situations can be analyzed.

The first situation is a non-testing mode with a proper connection via (310), (370) and (330) from the voltage supply to the electronic device. The switch (150) is open. Most of the supply current to the electronic device flows via (310), (370) and (330) due to its smaller resistance when compared with the other connections to the supply. Denote the current flowing in the supply line (500) $I_{DUT\_D}$, being the dominant current flow towards the Device Under Test (DUT) (10). The current flow through the resistance (350) is then $I_{DUT\_D} + I_1$ with $I_1$ being the current flow in branch (90) of the invented test device. Naturally this results in a voltage drop $V_x$ over the resistance (350). Thus in this non-testing, proper operation situation, the current mirror of the test device will be unbalanced, meaning that the ratio of the currents in the branches (90), (100) will deviate from the ratio expected from the transistor dimensions.

The second situation is a non-testing mode with a non-proper, potentially broken, connection via (310), (370) and (330) from the voltage supply to the electronic device. The resistance of that pathway is thus very large. The current flow via said pathway can be assumed to be small or even zero. The switch (150) is open. Most of the supply current to the electronic device flows via (300), (360) and (320) due to its smaller resistance when compared with the non-proper connection to the supply. The current flow through the resistance (350) is then $I_2$ with $I_2$ being the current flow in branch (100) of the invented test device. Naturally this results in a voltage drop over the resistance (350). Note that said voltage drop is of reversed sign when compared with the voltage drop in the first situation. Thus in this non-testing, non-proper operation situation, the current mirror of the test device will be unbalanced, meaning that the ratio of the currents in the branches (90), (100) will deviate from the ratio expected from the transistor dimensions, but this unbalance will be in the other direction, due to the sign reversal of the voltage drop $V_x$.

The third situation is a testing mode with a non-proper, potentially broken, connection via (310), (370) and (330) from the voltage supply to the electronic device. The resistance of that pathway is thus very large. The current flow via said pathway can be assumed to be small or even zero. The switch (150) is closed. Thus an extra and large test current will be drawn via said switch. Most of the supply current to the electronic device and said test current flows via (300), (360) and (320) due to its smaller resistance when compared with the non-proper connection to the supply. The current flow through the resistance (350) is then $I_2$ with $I_2$ being the current flow in branch (100) of the invented test device. As in the second situation, this results in a voltage drop $V_x$ over the resistance (350) and results in an unbalanced operation of the current mirror. When analyzing the current differences in the branches (90) or (100) in this third situation one can take a conclusion about the connection under test. If the current difference of situation three and two are the same, one can conclude that the connection is broken or not proper.

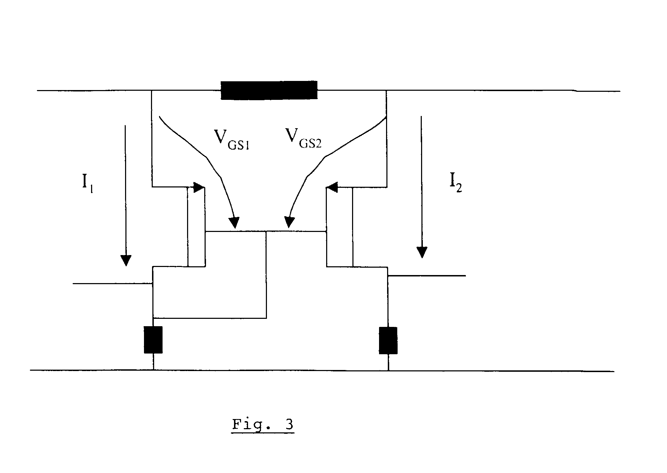

The fourth situation is a testing mode with a proper connection via (310), (370) and (330) from the voltage supply to the electronic device. The switch (150) is closed. Thus an extra and large test current will be drawn via said switch. Most of the supply current to the electronic device and the test current ITEST flows via (310), (370) and (330) due to its smaller resistance when compared with the other connections to the supply. Denote the current flowing in the supply line (500) $I_{DUT\_D} + I_{TEST}$, with $I_{DUT\_D}$ being the dominant current flow towards the Device Under Test (DUT) (10). The current flow through the resistance (350) is then $I_{DUT\_D} + I_{TEST} + I_1$ with $I_1$ being the current flow in branch (90) of the invented test device. Naturally this results in a voltage drop $V_x$ over the resistance (350). This voltage drop will be larger than the voltage drop encountered in the other situations as the large test current flow mainly through the resistance (350). The current mirror of the invented test device will be more unbalanced than in the first situation. Moreover when compared to the other testing mode, described in the third situation, these voltage drop have another sign. Although both the third and fourth situation result in unbalanced current mirrors, the comparison of the currents will be totally different due to the sign reversal of the voltage drop and the value of the currents flowing. When analyzing the current differences in the branches (90) or (100) in this third situation one can take a conclusion about the connection under test. If the current difference of situation four is larger than in situation one, one can conclude that the connection is proper. Suppose that the invented test device comprises of a typical current mirror configuration although the invention is not limited to that. Such a configuration is shown in Figure 3. In ideal current mirror operation, the MOS transistor 1 and 2 have the same gate to source voltage $V_{GS1}$ and $V_{GS2}$ thus following the MOS transistor current formula's (A) and (B), the currents will satisfy the relationship (C). $W_1$, $L_1$ are the width

and length of transistor 1. $W_2$, $L_2$ are the width and length of transistor 2.

$$I_1 = K (W_1/L_1) (V_{GS1} - V_T) \qquad (A)$$

$$I_2 = K (W_2/L_2) (V_{GS2} - V_T) \qquad (B)$$

$$I_1 (L_1/W_1) = I_2 (L_2/W_2) \qquad (C)$$

In the operation of such a typical current mirror as described in the invention the following relationship between the currents is established:

$$I_1 (L_1/W_1) - I_2 (L_2/W_2) = V_x$$

In the first situation (non-testing mode with a proper connection) : $V_x = R_X (I_{DUT\_D} + I_1)$.
In the second (non-testing mode with a non-proper connection) and third (test mode - non-proper connection) situation $V_x = - R_X I_2$.
In the fourth situation (test mode - proper connection) $V_x = R_X (I_{DUT\_D} + I_1 + I_{TEST})$.
When comparing the non-testing mode of situation one and the test mode of situation four, both having a proper connection, it can be said that the mirror circuit is driven further in unbalance when the connection is proper.
In the case with a faulty or non-proper connection, found in situation two and three, a small voltage drop is found, thus the mirror circuit can be considered to be nearly in balance. Therefore it can be said that said circuit is coming to a nearly balance condition when the connection is faulty.
The monitoring of the currents (directly or indirectly) and comparing them whereby the dimensions of the transistors are taken into account, results in a conclusion about the connection under test. The non-testing mode situations one and two can be used as reference situations. It is clear that the use of this typical current mirror as described results in a high sensitivity of detection of connectivity problem in the supply connections. Naturally any electronic circuit with current mirror type of operation can be used in the invention.
In an alternative approach the dimensions of the transistors of the current mirror circuit used in the invention can be adapted in order to increase even the sensitivity of the test device more. Suppose that under normal current mirror operation, thus no voltage drop of the connections of the branches of said current mirror circuit, a first ratio between the currents of said branches is found while said current mirror circuit is in balance. In fact balanced means here that said ratio of said currents is being determined by the transistor dimensions. One can enhance the sensitivity of said test device by changing said current mirror transistor dimensions such that in the second and third situation with non-proper connection said current mirror is in balance, meaning said currents in said branches are equal to said first ratio, although there is a voltage drop between its connections. As current mirrors are extremely designed for satisfying said ratio condition on its currents even under severe conditions, its going in unbalance will clearly indicate the cause, here pulling a current via said switch via a proper connection, resulting in a voltage drop. Said approach of changing transistor parameters results in fact in changing the reference situation. It can be said that said current mirror is being adapted in order to be in balance for a reference situation. Each of said situations described before (first, second, third and fourth) can be used as reference situation for which said current mirror is adapted in order to be in balance.
The invention describes thus a device for testing a supply connection of an electronic device by measuring a test current flowing in said supply connection. The invented device is characterized in that said device comprises at least of a current mirror, being characterized by at least two branches, at least one end of each of said branches being connected to an different location of the supply connection to said electronic device. Said current mirror is adapted for generating an output voltage, being related to said test current.
Such output voltage can be generated by comparing the currents in the branches (90) and (100). When no test current flow through the resistance (350), being the case in situation three, another difference in currents will be observed than in the situation four, where the test current flows through the resistance (350).
The invention describes thus a method for testing a supply connection of an electronic device by measuring a test current flowing in said supply connection. Indeed when a test current is forced to flow, depending whether the connection is proper or not, in test mode another difference in currents in the branches of the current mirror will be observed. Said difference can be used for generating an output voltage, for instance via a comparator circuit. Said output voltage is thus related to said test current. In the method one can determine a first output voltage being said output voltage for zero test current as in situation one and two. Also a second output voltage, being said output voltage while forcing said test current, can be determined as in situation three or four. When comparing said first and second output voltage, one generates a third output voltage, from which one can conclude about the connection under test.
The invention, although its primarily intended to be used to verify the power and ground connections once the packaged device is mounted on a board or a system interconnect structure, can also be used during other phases of the test process, such as wafer sort testing - to verify if each of the power/ground probe pins is properly making contact and hence increases the useable lifetime of the probe card -, or at packed device test level - providing continuity checks for power and ground pins -. It can also be used to provide continuity checks for pins other than power and ground pins, for which the traditional approach by measuring the ESD protection diodes fails, such as analog in- and outputs.

Said test device can also be applied for measuring via the ring resistance (340), such that the two adjacent power-ground supply connections can be tested. As said test device is assymetricaly, meaning more sensitive to a current flowing in a first direction than a current flowing in a second direction, for such an approach one could use two such test devices, but with their connections being connected in an opposite way. The advantage of such an approach can be that more space for integrating said device under said ring resistance is available.

Said test device can be adapted such that in non-testing mode it can go in power-down mode.

Note that said test device can be exploited also for current measuring, and can for instance be used for detecting whether the current drawn by device (10) exceeds a certain threshold.

To validate and evaluate the test device operation and the related test method, a particular test device or monitor design was carried out, although the invention is not limited hereto.

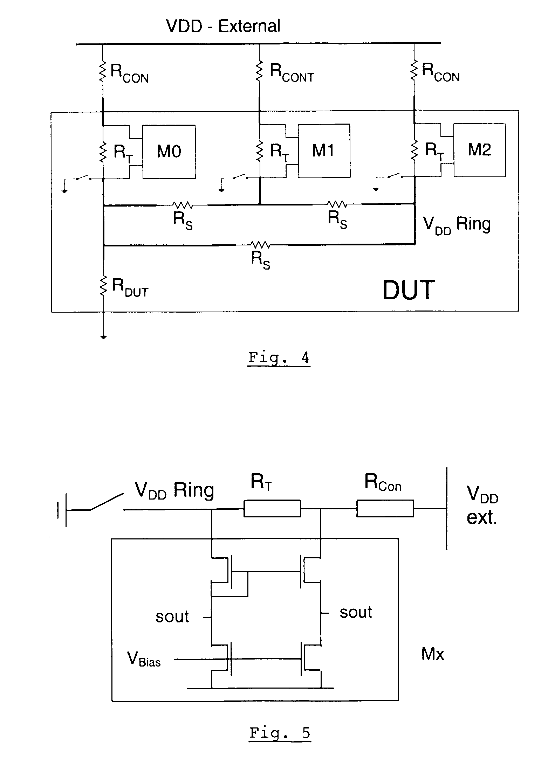

Figure 5 represents a test device according to a preferred embodiment of the invention comprising of a current mirror, which branches are connected to a different location of a supply line towards the device under test, here referred to as the inner voltage ring.

Transistor dimensions were calculated based on Alcatel Microelectronics' 0.7 $\mu$m CMOS process. Numerous simulations, including Monte-Carlo ones, were carried out to evaluate the behavior of the monitor within the process boundaries (using Slow, Typical and Fast process parameters) as well as under the influence of mismatch ($V_T, \beta$). To carry out the simulations, the test structure as shown in figure 4 was used. The test structure represents a situation where three supply connections are used to feed the circuit (DUT). The connection between the external $V_{DD}$ and the internal $V_{DD}$ ring is represented by 2 resistors, $R_{Con}$ being the resistance of soldering and bonding wire and RT being the resistance of the on-chip wiring between power pad and the internal supply ring. Each segment of the internal $V_{DD}$ ring is modeled as a resistor $R_S$. Across each resistor $R_T$ a monitor is connected, as illustrated in figure 5.

To model a defect, being a bad soldering connection or a bad bonding connection or a combination of both, the value of one of the $R_{Con}$ resistors, namely $R_{ConT}$ was changed over the simulations. The nominal values used for the different modeling resistors are: $R_{Con}$: 200 m$\Omega$, $R_T$: 10 m$\Omega$ and $R_S$: 300 m$\Omega$. The value of $R_{DUT}$ was set to 100 MegQ. For a faulty connection $R_{ConT}$ was set to 200 Meg$\Omega$. The $V_{DD}$ voltage was set to 3.3V. To illustrate the operation of the monitor and its effectiveness, some of the simulation results are added hereafter.

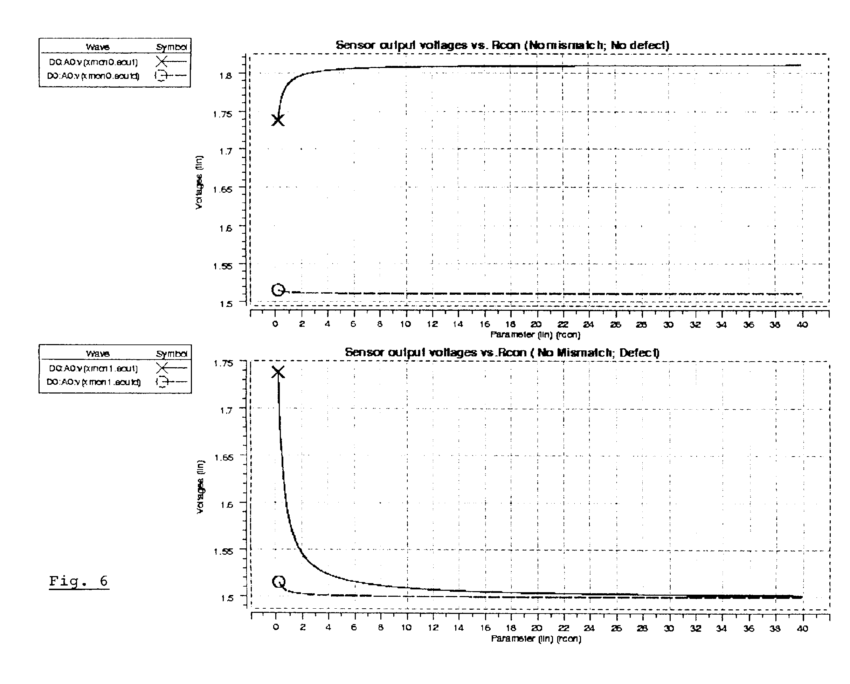

Figure 6 shows voltage outputs of the branches of said test device of Figure 5 and illustrates substantially different behavior, represented here by comparison of said voltage outputs of said test monitor, depending whether a faulty or non-proper connection is there or not.

More precisely, Figure 6 shows the behavior of the internal monitor nodes Sout and Soutd in function of the value of the connection-modeling resistor $R_{ConT}$. The top graph shows the nodes on monitor M0, adjacent to the connection under test, and the bottom graph shows the internal nodes of monitor M1, monitoring the faulty connection. These graphs clearly show the principle of using a unbalanced mirror, where the mirror is driven further in unbalance when the connection is proper (top graph) and where the mirror is coming to a balance condition when the connection is faulty (bottom graph) and hence the potential to make a decision on the quality of the connection, based upon the voltages at at least one of the nodes of said mirror. Alternatively comparing both voltages with voltage comparators can be used or also comparing the current in the branches of said mirror can be exploited.

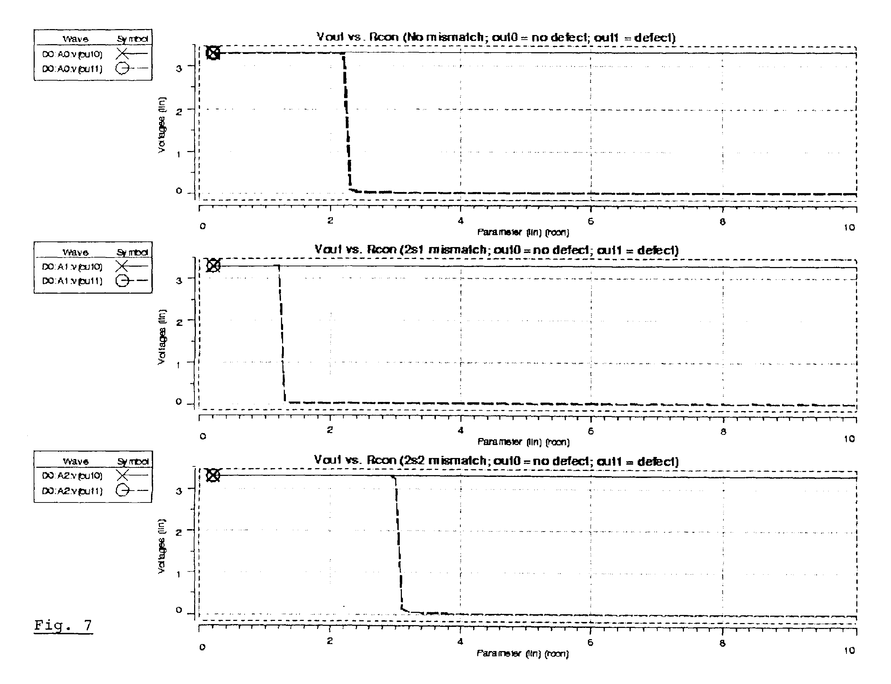

Figure 7 shows the output of said test device of Figure 5, said output being generated by comparing said voltage outputs of said branches through a comparator. Said Figure shows the sensitivity of said test device for detecting faulty or non-proper connections and its robustness against mismatches.

More precisely, Figure 7 shows the output of the monitor structure, in function of the value of the connection modeling resistor $R_{ConT}$, and taking into account different mismatch situations. Each of the graphs shows the output of a monitor M0 connected to a proper connection (full line) and the output of the monitor M1 connected to the 'faulty' connection (dashed line). The top graph shows the reaction of these monitors for typical process parameters and when no mismatch is taken into account. The middle graph shows the influence of $V_T$ mismatch and the bottom graph shows the influence of $\beta$ mismatch. In all cases detection of the 'faulty' connection (being a connection resistance > 1.5 $\Omega$, being 7.5 times the normal connection resistance and determined by the comparators' switching level) is guaranteed.

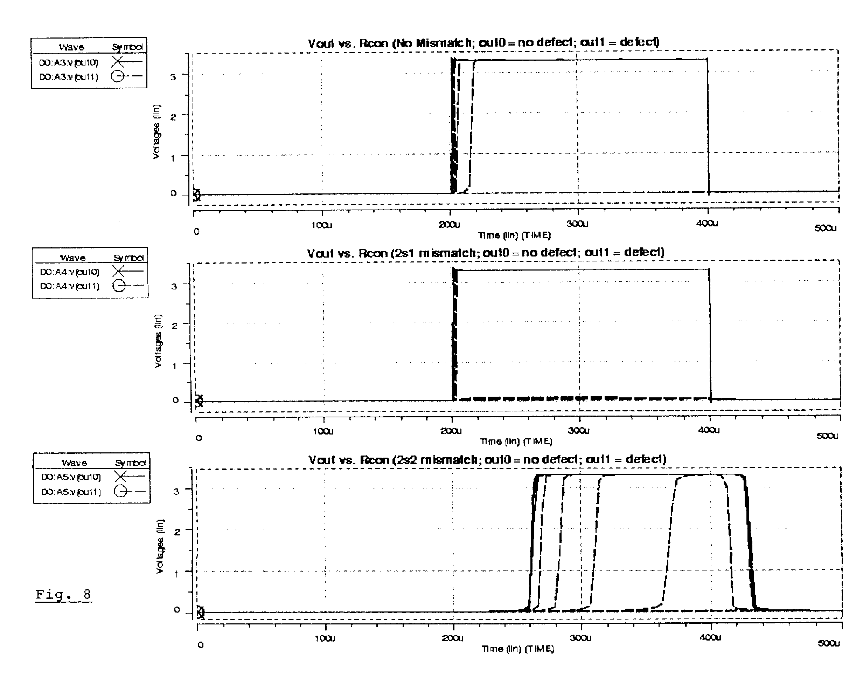

Figure 8 shows the time dynamics of the testing method, by distinguishing non-testing and testing phases. In the non-testing phase, no test current is available. In the testing phase, a test current is pulled through switches and depending whether a non-proper or faulty connection is found, different dynamics of said test device, is observed. Robustness against mismatches is also illustrated.

More precisely, Figure 8 shows a collection of simulation results, illustrating the time behavior of the outputs of monitors M0 and M1, the latter one connected to the 'faulty' connection, in function of the value of the connection modeling resistor $R_{ConT}$, and taking into account different mismatch situations. During the intervals 0 - 200 µs and 400 - 500 µs the switches are open, and thus the device is in non-testing mode, and during the interval 200 - 400 µs the switches are closed, for pulling a test current. The top graph shows the reaction of these monitors for typical process parameters and when no mismatch is taken into account. The middle graph shows the influence of $V_T$ mismatch and the bottom graph shows the influence of β mismatch. In all cases detection of the 'faulty' connection (being a connection resistance > 1.5 Ω, being 7.5 times the normal connection resistance and determined by the comparator's switching level) is guaranteed. The typical reaction time of the monitor is 20 µs, where the worst case reaction time is 170 µs.

## Claims

1. A device for testing a supply connection (80) of an electronic device (10) by measuring a test current flowing in said supply connection (80), said device being characterized in that said test device comprises at least of a current mirror (20), being characterized by at least two branches (90, 100), at least one end of each of said branches being connected to an different location of the supply connection (80) to said electronic device (10), said current mirror (20) being adapted for generating an output voltage (140), being related to said test current.

2. A device as recited in claim 1, further comprising means (150) for forcing said test current through said supply connection (30).

3. A device as recited in claim 1 or 2, further comprising means (160) for sampling said output voltage.

4. A device as recited in any one of the preceding claims, wherein said test device (120) being integrated with said electronic device (10) on one integrated circuit (130).

5. A device as recited in any one of the preceding claims, wherein said electronic device (10) being a CMOS device.

6. A device as recited in any one of the preceding claims, wherein said test current flowing in said electronic device (10).

7. A device as recited in any one of the preceding claims, wherein said current mirror (20) being adapted in order to be in balance for a reference situation.

8. A method for testing a supply connection of an electronic device by measuring a test current flowing in said supply connection, said method comprises at least the step: generating an output voltage with a current mirror, being characterized by at least two branches, by connecting at least one end of each of said branches to a different location of the supply connection to said electronic device, said output voltage being related to said test current.

9. The method as recited in claim 8, wherein said test current being forced through said supply connection.

10. The method as recited in claim 8, further comprising the steps:

    determining a first output voltage being said output voltage for zero test current;
    determining a second output voltage being said output voltage while forcing said test current;
    generating a third output voltage based on said first and second output voltage.

11. The method as recited in claim 8, said electronic device being a CMOS device.

12. The method as recited in claim 8, said test current flowing in said electronic device.

Fig. 1

Fig. 2

Fig. 3

VDD - External

$R_{CON}$    $R_{CONT}$    $R_{CON}$

$R_T$  M0    $R_T$  M1    $R_T$  M2

$R_S$    $R_S$

$V_{DD}$ Ring

$R_S$

$R_{DUT}$    DUT

Fig. 4

$V_{DD}$ Ring    $R_T$    $R_{Con}$    $V_{DD}$ ext.

sout    sout

$V_{Bias}$    Mx

Fig. 5

Fig. 6

Fig. 7

13

Fig. 8

**European Patent Office**

**EUROPEAN SEARCH REPORT**

Application Number

EP 99 87 0202

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| X | EP 0 386 804 A (PHILIPS NV) 12 September 1990 (1990-09-12) see abstract --- | 1-12 | G01R31/316 |
| X | DE 44 34 792 C (TELEFUNKEN) 23 May 1996 (1996-05-23) * claim 1; figure 1 * --- | 1-12 | |
| X | EP 0 525 421 A (TEXAS INSTR.) 3 February 1993 (1993-02-03) see abstract ----- | 1,2,6-10 | |
| | | | **TECHNICAL FIELDS SEARCHED (Int.Cl.7)** G01R |

The present search report has been drawn up for all claims

| Place of search | Date of completion of the search | Examiner |
|---|---|---|
| THE HAGUE | 6 March 2000 | Hoornaert, W |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 1 089 082 A1

## ANNEX TO THE EUROPEAN SEARCH REPORT
## ON EUROPEAN PATENT APPLICATION NO.

EP 99 87 0202

This annex lists the patent family members relating to the patent documents cited in the above-mentioned European search report.
The members are as contained in the European Patent Office EDP file on
The European Patent Office is in no way liable for these particulars which are merely given for the purpose of information.

06-03-2000

| Patent document cited in search report | | Publication date | Patent family member(s) | | Publication date |
|---|---|---|---|---|---|
| EP 386804 | A | 12-09-1990 | NL | 8900050 A | 01-08-1990 |
| | | | DE | 69004830 D | 13-01-1994 |
| | | | DE | 69004830 T | 19-05-1994 |
| | | | JP | 2227670 A | 10-09-1990 |
| | | | KR | 142080 B | 15-07-1998 |
| | | | US | 5057774 A | 15-10-1991 |
| DE 4434792 | C | 23-05-1996 | NONE | | |
| EP 525421 | A | 03-02-1993 | DE | 4122029 C | 26-11-1992 |
| | | | US | 5347174 A | 13-09-1994 |
| | | | JP | 5232147 A | 07-09-1992 |

EPO FORM P0459

For more details about this annex : see Official Journal of the European Patent Office, No. 12/82

16